(19) **Europäisches Patentamt**
**European Patent Office**
**Office européen des brevets**

(11) **EP 4 668 580 A1**

(12) **EUROPEAN PATENT APPLICATION**

(43) Date of publication:
**24.12.2025 Bulletin 2025/52**

(21) Application number: **24183669.1**

(22) Date of filing: **21.06.2024**

(51) International Patent Classification (IPC):
**H03H 9/02** *(2006.01)* **H03H 9/24** *(2006.01)*

(52) Cooperative Patent Classification (CPC):
**H03H 9/2463; H03H 9/02259**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**GE KH MA MD TN**

(71) Applicant: **Institute of Science and Technology Austria**
**3400 Klosterneuburg (AT)**

(72) Inventors:
• **Puglia, Denise**
  **3400 Klosterneuburg (AT)**
• **Odessey, Rachel**
  **3400 Klosterneuburg (AT)**
• **Higginbotham, Andrew Patrick**
  **3400 Klosterneuburg (AT)**

(74) Representative: **J A Kemp LLP**
  **80 Turnmill Street**
  **London EC1M 5QU (GB)**

(54) **ELECTROMECHANICAL DEVICE**

(57)     Provided is an electromechanical device comprising: a mechanical resonator comprising a first surface, an electrode, and a controller. The first surface opposes the electrode and is separated from the electrode. The controller is configured to apply a DC bias voltage either a) between the first surface and the electrode, or b) between first and second regions of the electrode. The DC bias voltage and a configuration of the mechanical resonator and the electrode are such that strong coupling is achieved in use between mechanical motion of the mechanical resonator and an electromagnetic signal applied to one of the first surface and the electrode.

Fig. 1

## Description

The present invention relates to devices for coupling electromagnetic radiation to mechanical motion.

The coupling between optical fields and mechanical motion is famously weak. In nature, the light-matter interaction does not change the properties of the matter involved and can be understood as a perturbation. It is taken almost for granted that, in order to achieve appreciable couplings, this interaction must be resonantly enhanced with a cavity [1, 2], or special piezoelectric materials must be used. These two strategies have had an enormous impact on science and technology. Cavity optomechanics has been used to control mechanical motion at the quantum level [3] and piezoelectric materials are the basis of widely used timekeeping and signal processing devices.

Without the use of a cavity, substantial optomechanical coupling has nevertheless been achieved at optical frequencies. However, at radio and microwave frequencies, cavity-free coupling has so far been impractically weak unless special piezoelectric materials are used.

Given these successes, it is desirable to identify strategies for improving optomechanical coupling in order to enable further applications.

According to a first aspect of the present disclosure, there is provided an electromechanical device comprising: a mechanical resonator comprising a first surface; an electrode; and a controller, wherein: the first surface opposes the electrode and is separated from the electrode; the controller is configured to apply a bias signal comprising a DC bias voltage either a) between the first surface and the electrode, or b) between a first region of the electrode and a second region of the electrode; and the DC bias voltage and a configuration of the mechanical resonator and the electrode are such that strong coupling is achieved in use between mechanical motion of the mechanical resonator and an electromagnetic signal applied to one of the first surface and the electrode.

By choosing this specific structure for the electromechanical device, with opposed surfaces of the electrode and mechanical resonator, the configuration of the resonator can be engineered to maximise mode matching. This in combination with the application of a DC bias voltage allows the device to be configured to provide strong coupling.

Optionally, the configuration of the mechanical resonator and the electrode comprises one or more of: a) a separation of the first surface from the electrode; b) a quality factor of the mechanical resonator; and c) dimensions of the mechanical resonator and/or the first surface. These parameters affect the capacitance between the mechanical resonator and the electrode, and also the internal losses in the mechanical resonator. Thereby, choosing appropriate configurations of these parameters affects the relative balance of the coupling and the internal losses that determines whether strong coupling can be achieved.

Optionally, the device further comprises a first transmission line electrically connected to one of the first surface and the electrode for application of the electromagnetic signal. This allows signals to be introduced to the device.

Optionally, the other of the first surface and the electrode is grounded. This enables certain types of measurement with the device, such as bath thermometry.

Optionally, the device further comprises a second transmission line electrically connected to the other of the first surface and the electrode. This allows for read out of signals from the device.

Optionally, the DC bias voltage is between 0.1 V and 30 V, optionally between 0.5 V and 5 V. The strength of the bias voltage determines the equilibrium separation of the first surface of the mechanical resonator from the electrode, thereby allowing for tuning of the capacitance between the mechanical resonator and the electrode.

Optionally, a separation of the first surface from the electrode when no DC bias voltage is applied by the controller is between $0.05\mu m$ and $5\mu m$, optionally between $0.1\mu m$ and $3\mu m$. This separation provides an appropriate value of capacitance between the mechanical resonator and the electrode.

Optionally, a quality factor of the mechanical resonator is greater than 500, optionally greater than 1000. A higher quality factor reduces internal losses in the mechanical resonator, thereby making it easier to achieve strong coupling.

Optionally, a fundamental resonance frequency of the mechanical resonator 1 when no DC bias voltage is applied by the controller is between 50 kHz and 5 MHz, optionally 300 kHz and 600 kHz. This is a typical frequency range for mechanical resonators of the type most suitable for use in this device. It is also challenging for existing devices such as quartz-crystal oscillators to achieve good coupling in this frequency range.

Optionally, one or more of: a) an area of the first surface is between $1\mu m^2$ and $25mm^2$, optionally between $50,000\mu m^2$ and $300,000\mu m^2$; b) a smallest dimension of the first surface is at least 100nm, optionally at least $1\mu m$, optionally at least $50\mu m$; and c) mode matching of the electrode and the first surface is at least 20%, optionally at least 50%, optionally at least 80%. These parameters enable the capacitance and mode-matching of the mechanical resonator and the electrode to be optimised to achieve strong coupling. They also produce a device that is of a suitable size for typical commercial applications.

Optionally, the mechanical resonator comprises a membrane. Membranes can be engineered with appropriate size and structural properties for use in the device, and their size and can be selected to provide sufficient mode matching for achieving strong coupling.

Optionally, the membrane comprises silicon nitride. Silicon nitride is a well-known material for producing membranes of the sizes required for this device.

Optionally, the membrane is soft-clamped at its edges. Soft clamping reduces the damping of the membrane and therefore improves its quality factor.

Optionally, a thickness of the membrane is at most 300nm, optionally at most 200nm, optionally at most 100nm. This provides appropriate resonant frequencies for the applications typical for the device.

Optionally, the first surface is electrically conductive, optionally wherein the first surface comprises a metal, for example aluminium, graphene, or a superconducting material. A metallised membrane has improved coupling properties to input lines and the electrode surface. Optionally, the first surface comprises a metal and a thickness of the metal is at most 150nm, optionally at most 100nm, optionally at most 50nm. These are appropriate thicknesses to provide coupling without damping the membrane or otherwise adversely affecting its resonant properties.

Optionally, the electrode comprises a) graphene, or b) a metal, for example platinum or aluminium, optionally wherein a thickness of the metal is at most 200nm, optionally at most 100nm, optionally at most 50nm. These conductive materials are suitable for deposition when fabricating the device, and having appropriate conductive properties for coupling to the mechanical resonator.

According to a second aspect of the present disclosure, there is provided an amplifier comprising the electromechanical device of the first aspect, wherein the controller is further configured to apply a parametric drive signal to the mechanical resonator. Amplification is challenging in the frequency regime typical for the device using conventional approaches. The strong coupling enables improved amplification performance.

According to a third aspect of the present disclosure, there is provided a bandpass filter or an inductor comprising the electromechanical device of the first aspect. The strong coupling allows for components with low insertion loss and wide bandwidth compared to existing components.

According to a fourth aspect of the present disclosure, there is provided a method of coupling an electromagnetic signal to mechanical motion using an electromechanical device, wherein the electromechanical device comprises: an electrode; and a mechanical resonator comprising a first surface opposing the electrode and separated from the electrode, the method comprising: applying a DC bias voltage either a) between the first surface and the electrode, or b) between a first region of the electrode and a second region of the electrode; and applying the electromagnetic signal to the first surface or the electrode, wherein the DC bias voltage and a configuration of the mechanical resonator and the electrode are such that strong coupling is achieved between mechanical motion of the mechanical resonator and the electromagnetic signal.

By choosing this specific structure for the electromechanical device, with opposed surfaces of the electrode and mechanical resonator, the configuration of the resonator can be engineered to maximise mode matching. This in combination with the application of a DC bias voltage allows the device to be configured to provide strong coupling.

Optionally, a frequency of the electromagnetic signal is between 100kHz and 10MHz, optionally 300kHz and 600kHz. This is a typical frequency range for mechanical resonators of the type most suitable for use in this device. It is also challenging for existing devices such as quartz-crystal oscillators to achieve good coupling in this frequency range.

Embodiments of the invention will now be described, by way of example only, with reference to the accompanying drawings in which corresponding reference symbols represent corresponding parts, and in which

Fig. 1 shows a schematic circuit diagram of an electromechanical device 1;

Fig. 2 shows a view of a central region of the device of Fig. 1;

Fig. 3 is a photograph of an example device;

Fig. 4 shows the transmission coefficient $S_{21}$ measured across the device as a function of the DC bias voltage;

Fig. 5 shows the electromechanical coupling $g$ and internal dissipation $\kappa_{in}$ as a function of the DC bias voltage;

Fig. 6 shows the cooperativity as a function of DC bias voltage;

Fig. 7 compares $S_{21}$ around the resonance and anti-resonance for a quartz crystal oscillator and the device;

Fig. 8 shows the dependence of the anti-resonance and resonance frequency on DC bias voltage;

Fig. 9 shows the imaginary and absolute impedance of the data shown in Fig. 7;

Fig. 10 shows an inductor quality factor for a quartz crystal oscillator and the device;

Fig. 11 shows inductor bandwidth for a quartz crystal oscillator and the device;

Fig. 12A to Fig. 12C show measurements of the device when supplied with a parametric pump tone;

Fig. 13 illustrates a back-action isolation setup using the device;

Fig. 14 shows a voltage spectral density for the device thermalized to reference resistors at room temperature and liquid nitrogen temperature; and

Fig. 15 shows the numerically integrated area under the curve of Fig. 14 as a function of different apparent gains.

The present disclosure demonstrates an all-electric, movable parallel-plate capacitor system operating at room temperature with improved electromechanical coupling relative to existing devices. In particular, the system is able to reach the strong electromechanical coupling regime without the use of a cavity, as is common in existing approaches. This has relevance to recent efforts on achieving ground state cooling and sub-standard quantum limit without a cavity [4, 5, 6].

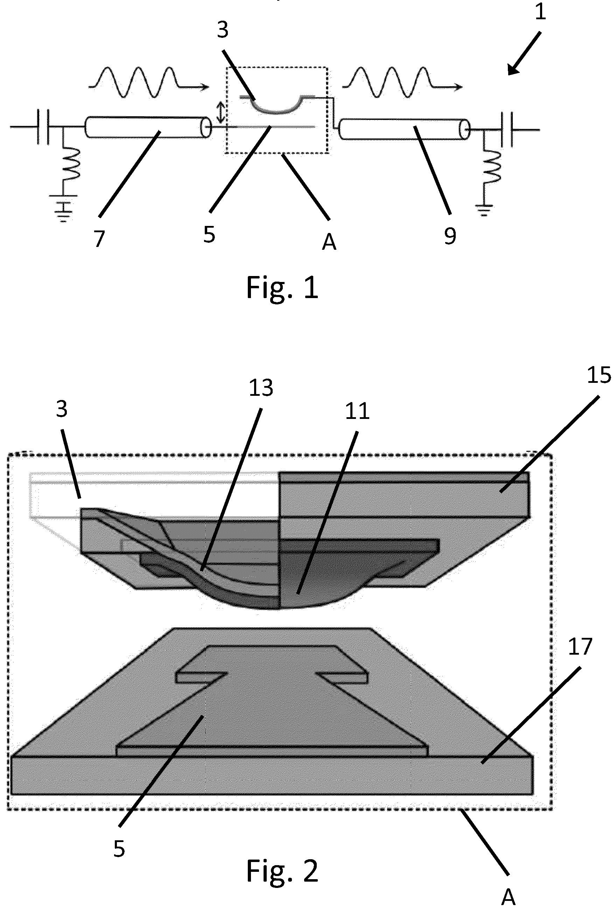

Fig. 1 shows a schematic circuit diagram of an electromechanical device 1 according to the present disclosure. The central region of the device A is shown in greater detail in Fig. 2, with the front left quadrant of the upper part of the device 1 shown only in contour lines to illustrate the cross-section.

The device 1 comprises a mechanical resonator 3. In order to improve the performance of the device 1, it is preferable that the internal dissipation of energy in the resonator 3 is low. For this reason, a quality factor of the mechanical resonator 1 may be greater than 500, optionally greater than 1000, optionally greater than 2000.

The mechanical resonator 3 comprises a deformable and/or displaceable element which oscillates or vibrates to provide the resonant behaviour. Any suitable mechanical resonator 3 may be used. For example, the mechanical resonator 3 may comprise a clamped beam or trampoline resonator. In particular, the mechanical resonator 3 may comprise a membrane 11, as shown in Fig. 2. The mechanical resonator may comprise a support 15 that supports the membrane 11 (or other deformable and/or displaceable element). The membrane 11 may be soft-clamped at its edges to reduce damping of vibrations of the membrane 11, but this is not essential.

The membrane 11 may comprise silicon nitride ($Si_3N_4$). One method to produce the membrane 11 is from Si wafers covered with 1 GPa stoichiometric $Si_3N_4$ on both sides. Using lithography, a window is defined on the back of the wafer where $Si_3N_4$ is removed through reactive ion etching. Most of the $Si_3N_4$ on the front side of the wafer is also removed, leaving only a first, larger square, which become the membrane 11. A plurality of smaller squares may also be defined, which become posts or spacers for supporting the membrane 11. The Si wafer is then dipped in KOH to etch the exposed silicon. The remaining silicon forms the support 15.

As shown in Fig. 2, the mechanical resonator 3 comprises a first surface 13. The first surface 13 is a surface of the deformable and/or displaceable element of the mechanical resonator 3 that oscillates or vibrates to provide the resonant behaviour. The resonant frequencies of the mechanical resonator 3 will be determined by the geometry of the mechanical resonator 3, and in particular of the first surface 13.

The first surface 13 may be electrically conductive. For example, the first surface 13 may comprise a metal such as aluminium, graphene, or a superconducting material. The conductive material of the first surface 13 may be deposited onto the mechanical resonator 3, for example by evaporation or any other suitable technique. In the example of Fig. 2, a 25nm layer of gold is deposited onto the membrane 11 to form the conductive first surface 13, with an intermediate 3nm sticking layer of titanium between the membrane 11 and the gold layer.

The device further comprises an electrode 5. The electrode 5 may be formed on a substrate 17, as shown in Fig. 2. The substrate 17 may be formed of the same material as the support 15, or may be any other suitable material. For example, the substrate 17 may comprise silicon.

The electrode 5 is electrically conductive, and may comprise any suitable conductive material such as a metal, for example platinum or aluminium, or graphene. Where the electrode 5 comprises a metal, there is no specific restriction on the thickness of the electrode 5 as long as other design requirements are met, such as the separation from the first surface 13 discussed below. However, typically a thickness of the metal may be at most 200nm, optionally at most 100nm, optionally at most 50nm. The conductive material of the electrode 5 may be deposited onto the substrate 17, for example by evaporation or any other suitable technique. In the example of Fig. 2, the electrode 5 is fabricated by evaporating 50 nm Pt onto a high resistivity silicon wafer that forms the substrate 17.

The first surface 13 opposes the electrode 5 and is separated from the electrode 5. This means that the first surface 13 and the electrode 5 together form a capacitor. This can be achieved by mounting the support 15 and substrate 17 at a suitable relative alignment and separation. The separation may be provided by spacers on the support 15 and/or the substrate 17.

The capacitor formed by the first surface 13 and the electrode 5 is a mechanically-compliant capacitor because the capacitor plate formed by the first surface 13 is able to move relative to the electrode 5 along the axis separating the first surface 13 and electrode 5. Thereby, the capacitance of the capacitor can be varied as the separation distance of the two plates varies with movement of the first surface 13.

In the embodiment of Fig. 2, top posts are formed on the support 15 during the process of forming the membrane 11. Corresponding bottom posts are also evaporated on the substrate 17 in a separate evaporation step to the forming of the electrode 5. The silicon support 15 comprising the membrane 11 is then flipped on top of the substrate 17 comprising the electrode 5 while carefully aligning the bottom and top posts. Finally, the support 15 and substrate 17 were bonded together, for example with an adhesive such as epoxy. The size of the posts defines the separation distance between the support 15 and substrate 17, and thereby contributes to determining the separation of the first surface 13 and the electrode 5.

The device 1 is configured such that a region between the electrode 5 and the first surface 13 is evacuated when the device 1 is placed into a vacuum. The typical size and construction of the mechanical resonator 3 means that the surroundings of the mechanical resonator 3 must be evacuated for it to function properly.

The device 1 may further comprise a first transmission line 7 electrically connected to one of the first surface 13 and the electrode 5 for application of an electromagnetic signal. In Fig. 1, the first transmission line 7 is connected to the electrode 5. The electromagnetic signal may be an oscillating signal. A frequency of the electromagnetic signal may be between 100kHz and 10MHz, optionally 300kHz and 600kHz.

The other of the first surface 13 and the electrode 5 may be grounded. Alternatively, as shown in Fig. 1, the device 1 may further comprise a second transmission line 9 electrically connected to the other of the first surface 13 and the electrode 5. In Fig. 1, the second transmission line 9 is connected to the mechanical resonator 3, and thereby the first surface 13. Either or both of the first transmission line 7 and the second transmission line 9 may be coaxial transmission lines and/or may have an impedance of 50 $\Omega$.

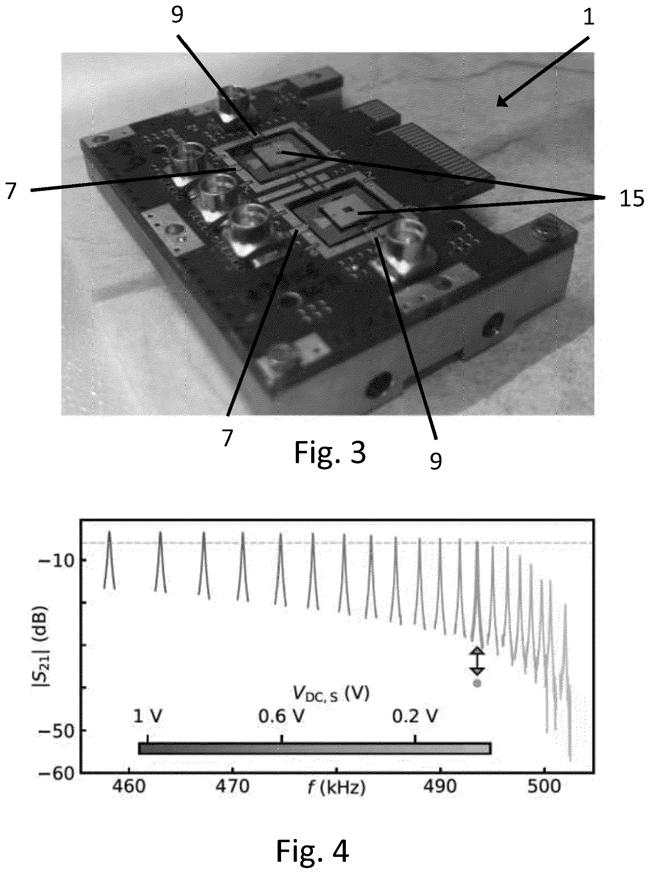

Fig. 3 shows an example device 1. Two devices are provided side-by-side on a single board. The square supports 15 are visible, along with connectors to allow external connections to the first and second transmission lines 7, 9. In this example, the membrane 11 is a square approximately 523$\mu$m wide, and the posts are approximately 350nm tall. After joining the support 15 and substrate 17 together, the first surface 13 and the electrode 5 form a capacitor approximately 521$\mu$m wide with approximately 330nm separation distance. The electrode 5 is fabricated by evaporating 50 nm Pt onto a high resistivity silicon wafer that forms the substrate 17. The first surface 13 is a metallised surface of the membrane 11 formed by depositing a 25nm layer of gold onto the membrane 11 with an intermediate 3nm sticking layer of titanium between the membrane 11 and the aluminium layer.

The device 1 further comprises a controller not shown in Fig. 1. The controller is configured to apply a bias signal comprising a DC bias voltage ($V_{DC}$) to the device 1. The bias signal may be applied between the first surface 13 and the electrode 5.

Alternatively, the electrode 5 may be divided into at least a first region and a second region, whereby the first region and the second region are electrically isolated from one another. In this case, the bias signal may be applied between the first region of the electrode 5 and the second region of the electrode 5. This embodiment may be used with a first surface 13 that is not electrically conductive, such that the oscillation of the first surface 13 is driven by dielectric force rather than capacitive forces. In such an embodiment, the first transmission line 7 would be connected to one of the first region and the second region. The second transmission line 9, if present would be connected to the other of the first region and the second region.

The DC bias voltage generates a static force between the first surface 13 and the electrode 5, pulling the first surface 13 closer to the electrode 5. This alters the equilibrium position of the first surface 13, thereby changing the oscillatory behaviour of the mechanical resonator 3. A fundamental resonance frequency of the mechanical resonator 1 when no DC bias voltage is applied by the controller may be between 50kHz and 5MHz, optionally 300kHz and 600kHz, optionally 400kHz and 500kHz. However, the resonant frequencies of the mechanical resonator 3 will be altered by the DC bias voltage, depending on the magnitude of the DC bias voltage.

The DC bias voltage also shifts the separation distance between the first surface 13 and the electrode 5, thereby tuning the coupling between the electromagnetic signal, applied via the first transmission line 7, and the mechanical resonator 3. The dynamic capacitance caused by the oscillation of the mechanical resonator 3 alters the external coupling to the electromagnetic signal and therefore the scattering parameters.

The DC bias voltage may be between 0.1V and 30V, optionally between 0.5V and 5V, optionally between 0.5V and 1V. The DC bias voltage may be at most 30V, optionally at most 20V, optionally at most 10V. This may be advantageous because many common types of electronic equipment used for these applications is limited to voltages of 30V or below. The DC bias voltage may be at least 0.1V, optionally at least 0.5V. As will be discussed further below, voltages of at least this magnitude provide a significant increase in coupling strength between the mechanical resonator 3 and the electromagnetic signal.

The device 1 enables a method of coupling an electromagnetic signal to mechanical motion using the electromechanical device 1. The method comprises applying the DC bias voltage either a) between the first surface 13 and the electrode 5, or b) between a first region of the electrode 5 and a second region of the electrode 5, and applying the electromagnetic signal to the first surface 13 or the electrode 5.

The DC bias voltage and a configuration of the mechanical resonator 3 and the electrode 5 are such that strong coupling is achieved in use between mechanical motion of the mechanical resonator 3 and an electromagnetic signal applied to one of the first surface 13 and the electrode 5.

As mentioned above, it is desirable to improve electromechanical coupling. In particular, it is desirable to reach the strong coupling regime. In the strong coupling regime, the cooperativity between two systems is larger than 1. In other words, the rate at which energy is exchanged between the two systems is larger than the rate at which energy is dissipated from the systems. In this case, this means that the total electromechanical coupling rate 2g must exceed all sources of internal dissipation $\kappa_{in}$. This is analogous to reaching the high-cooperativity regime in cavity optomechanics.

The device 1 described above allows this regime to be reached due to the opposed first surface 13 and electrode 5 forming a capacitor having variable capacitance combined with the use of the DC bias voltage and the configuration of the mechanical resonator 3 and the electrode 5. The coupling between the mechanical motion of the mechanical resonator 3 and the electromagnetic signal is therefore capacitive coupling, more specifically capacitive strong coupling.

In order to achieve the requirement that the electromechanical coupling rate 2g exceeds internal dissipation $\kappa_{in}$,

the electromechanical coupling can be tuned by $V_{\text{DC}}$ as $g = C'^2 V_{DC}^2 Z_0 / m$, where $C'$ is the derivative of the capacitance $C$ with respect to a coordinate $x$, $Z_0$ is the line impedance and $m$ is the effective mass of the oscillating element of the mechanical resonator 3, e.g. the membrane.. The coordinate $x$ parameterises the perpendicular displacement of the oscillating element of the mechanical resonator 3 (modelled as a mechanical spring) as a 1D coordinate of deflection from its equilibrium position in the absence of an applied DC bias voltage.

For a given geometry of the device 1, $V_{\text{DC}}$ is limited by the voltage that would collapse the mechanical resonator 3, so in some circumstances it may be preferable to maximise $C'$ rather than increase $V_{\text{DC}}$ in order to increase coupling.

For a capacitor with a moveable plate, where the space between the plates cannot be filled with a dielectric to increase capacitance, maximising $C'$ means having as small a separation distance and as large of an area as possible. This is achieved by appropriate choice of the configuration of the mechanical resonator 3 and the electrode 5.

To this end, the configuration of the mechanical resonator 3 and the electrode 5 such that strong coupling is achieved in use may comprise a separation of the first surface 13 from the electrode 5, in particular the separation of the first surface 13 from the electrode 5 when no DC bias voltage is applied by the controller. The separation of the first surface 13 from the electrode 5 when no potential is applied between the first surface 13 and the electrode 5 may be between $0.05\mu m$ and $5\mu m$, optionally between $0.1\mu m$ and $3\mu m$. The separation may be at most $3\mu m$, optionally at most $1\mu m$, optionally at most 500nm. A smaller separation increases the capacitance and thereby the coupling. The separation may be at least 50nm, optionally at least 100nm. A minimum separation may be desirable to reduce the likelihood of damage to the first surface 13 from contact with the electrode 5 during manufacture or use of the device 1. Preferably, the separation is approximately 300nm.

The configuration of the mechanical resonator 3 and the electrode 5 such that strong coupling is achieved in use may comprise a quality factor of the mechanical resonator 3. As discussed above, a quality factor of the mechanical resonator 1 may be greater than 500, optionally greater than 1000, optionally greater than 2000. A higher quality factor reflects lower internal dissipation.

The configuration of the mechanical resonator 3 and the electrode 5 such that strong coupling is achieved in use may comprise dimensions of the mechanical resonator 3 and/or the first surface 13.

Where the mechanical resonator 3 comprises a membrane 11, a thickness of the membrane 11 may be at most 300nm, optionally at most 200nm, optionally at most 100nm. The thickness of the membrane here refers to the total thickness including any layer that may be deposited to form the first surface 13. Where the first surface 13 comprises a metal, a thickness of the metal may be at most 150nm, optionally at most 100nm, optionally at most 50nm. A greater thickness of the membrane 11 increases its mass, which as shown by the equation above will reduce the coupling. A thinner membrane 11 is therefore preferable, provided the membrane 11 remains sufficiently thick to be mechanically robust and unlikely to be damaged during manufacture or use. A thickness of the membrane 11 may be at least 10nm, optionally at least 50nm.

An area of the first surface 13 may be between $1\mu m^2$ and $25mm^2$, optionally between $1,000\mu m^2$ and $1mm^2$, optionally between $50,000\mu m^2$ and $300,000\mu m^2$. The area of the first surface 13 may be at least $20,000\mu m^2$, optionally at least $50,000\mu m^2$, optionally at least $80,000\mu m^2$, optionally at least $150,000\mu m^2$, optionally at least $200,000\mu m^2$. The area of the first surface 13 may be approximately $90,000\mu m^2$, or approximately $250,000\mu m^2$.

A smallest dimension of the first surface 13 in the plane of the first surface 13 may be at least 100nm, optionally at least $1\mu m$, optionally at least $50\mu m$, optionally at least $100\mu m$. The first surface 13 may comprise a square having sides of at least $200\mu m$, optionally at least $300\mu m$, optionally at least $500\mu m$. Of course, having a first surface 13 that is too large may risk making the resonator unstable at the small separation distances required, and may prevent sufficient miniaturisation of the device 1. Therefore, a largest dimension of the first surface 13 in the plane of the first surface 13 may be at most 2mm, optionally at most 1mm.

The coupling can also be increased by strong mode matching between the mechanical resonator 3 and the electrode 5. To achieve this, the configuration of the mechanical resonator 3 and the electrode 5 may be such that mode matching of the electrode 5 and the first surface 13 is at least 20%, optionally at least 50%, optionally at least 80%, optionally at least 90%.

Many mechanical resonators possess an unavoidable parasitic antiresonance due to the presence of an electrostatic gate. This parasitic antiresonance reduces the transmission coefficient by causing a change in the imaginary component of the impedance. Therefore, to achieve strong coupling, it is advantageous to separate the frequency of the mechanical resonance from the frequency of the parasitic antiresonance.

The frequencies of both the mechanical resonance and the parasitic antiresonance are tuned by the applied voltage, but have different voltage dependencies. This enables the two to be separated.

The mechanical resonance $\Omega_m$ is tuned from its zero-voltage value for no applied DC bias by an electrostatic spring effect $\Omega_e$:

$$\Omega_m^2 = \Omega_0^2 - \Omega_e^2, \qquad\qquad (1)$$

where $\Omega_0$ is the zero-voltage resonance frequency in the absence of the DC bias voltage applied by the controller. The electrostatic spring shifts the frequency according to $\Omega_e = \dfrac{C''V_{DC}^2}{m}$, where $C''$ is the second derivative of the capacitance with respect to the coordinate x.

The antiresonance $\Omega_a^2$ is tuned according to

$$\Omega_a^2 = \Omega_m^2 + \frac{C'^2 V_{DC}^2}{mC}, \qquad\qquad (2)$$

where C' is the derivative of the capacitance with respect to x. This demonstrates that to have good detuning of the mechanical resonance and the antiresonance, it is necessary to have large $\dfrac{C'}{C}$ or a large x displacement for a given DC bias voltage compared to the zero-voltage separation distance, i.e. a large value of $\dfrac{x(V)}{x(V=0)}$.

As mentioned above, $V_{DC}$ may be limited by the voltage that would collapse the mechanical resonator 3. The equilibrium position $x_{eq}$ of the oscillating element of the mechanical resonator 3 depends on voltage. The dependence can found exactly by solving

$$x_{eq} = \frac{C'(x_{eq})V^2}{2m\Omega_m^2}.$$

Since C' depends on x, this gives a cumbersome expression. The important result is that for sufficiently strong voltages there are no longer stable minima. A parallel-plate capacitor with plate separation d collapses once $\dfrac{x_{eq}}{d} \approx 0.67$.

Results of measurements will now be described for the example device shown in Fig. 3. The device 1 of Fig. 3 comprises a silicon nitride membrane approximately $523\mu$m square, with a separation of approximately 330nm from the electrode 5. The membrane is metallised with a 25nm layer of gold. The electrode comprises a 50nm layer of platinum. In line with the configuration described above, these specific choices of parameters are suitable for achieving strong coupling. The DC bias voltage is applied between the electrode 5 and the first surface 13.

The device 1 was loaded into a vacuum chamber and kept at around $10^{-5}$ mbar and room temperature. The measurements were conducted using a lock-in amplifier for the probe tone and, when present, an arbitrary waveform generator was used for the pump tone. For two-port measurements, the pump and probe tones were added to the coupled port of a directional coupler. The mainline was grounded by a 50-ohm resistor. The AC electromagnetic signal was added to the DC bias voltage through a bias-tee and connected to the back of the membrane 11. The transmitted electromagnetic signal would travel from the electrode 5 directly to the input of the lock-in amplifier. The two-port measurement was converted to one-port with a 180 degrees hybrid coupler. The hybrid coupler recombines the scattering matrix elements with a phase, cancelling the transmitted contributions and returning the reflection parameter $S_{11}$ at the output port. The incoming signal follows a similar path as for the two-port measurement, passing through the mainline of an extra directional coupler. Through the coupled port of this directional coupler, we can read out the reflected wave from the device.

Fig. 4 shows the transmission coefficient $S_{21}$ measured across the device versus frequency for different DC bias voltages $V_{DC}$. The dashed green line indicates expected threshold transmission when the device is operated in the strong coupling regime $2g > \kappa$in.

As $V_{DC}$ increases, three effects can be observed: the resonant frequency decreases, the resonant bandwidth broadens, and the resonant transmission increases. At 0 V, a narrow, resonant peak in transmission is observed. As voltage is increased, the resonance grows and widens, as expected for an increasing electromechanical coupling. For larger voltages, the transmission on resonance becomes voltage independent, flattening out and saturating at approximately -4 dB.

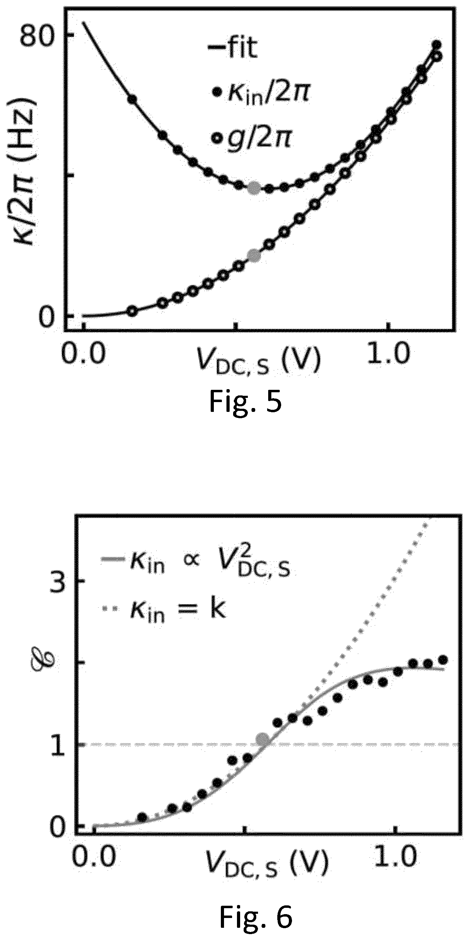

Fig. 5 shows the electromechanical coupling g and internal dissipation $\kappa_{in}$ plotted as a function of the DC bias voltage as extracted using Lorentzian fits. The solid green marker point was calculated from the resonance indicated by the arrow in Fig. 4. The solid line represents the voltage dependence fit.

The fitting reveals that g grows quadratically with $V_{DC}$, as expected. However, we consistently find that external coupling is minimized at non-zero applied DC voltage $V_{DC}$, presumably due to interfacial charges. This motivates the use of a shifted bias $V_{DC,S}$ = $V_{DC}$-$V_0$, where $V_0$ is sample dependent. The voltage offset is determined by fitting g($V_{DC,S}$) to

$$g = C'^2 V_{DC,S}^2 Z_0 / m$$

.

Internal dissipation is non-monotonic in $V_{DC,S}$, reaching for this sample a minimum near $V_{DC,S}$ = 0.6V (corresponding to $V_{DC} \approx$ 0.4 V) and growing for large voltage , eventually matching the growth in g, which is the origin of the saturation in resonant transmission at large voltages. We speculate that the quadratic voltage-dependence of $\kappa_{in}$ is due to parasitic inline resistance from the electrodes [7]. The minimum internal dissipation is limited to around 36±8 Hz for this sample, but reaches values down to 5±2 Hz for other samples.

The total strength of the electromechanical coupling relative to dissipation can be measured with a dimensionless "cooperativity" parameter, C = 2g/$\kappa_{in}$, which plays the same role as cooperativity in cavity optomechanics. Fig. 6 plots the cooperativity as a function of DC bias voltage. The larger green marker is calculated from the resonance indicated by the arrow in Fig. 4. The dashed green line shows C = 1, above which the device is considered to operate in the strong coupling regime. The solid line indicates the expected cooperativity based on the voltage dependence fit from Fig. 5, while the dotted line indicates the expected cooperativity for a constant internal coupling.

As voltage is increased, the cooperativity parameter C increases from a small value, crossing into the > 1 strong coupling regime. This signals that the light-matter interaction has entered into a regime where mechanical motion is damped primarily by radiation in the leads.

Strong-coupling transmission line electromechanics opens up new avenues for electromechanical devices in regimes that are challenging for existing technology. For example, a bandpass filter or an inductor may be provided comprising the electromechanical device 1 described above.

An advantage of the present device is that it functions as an all-electrical device. In particular, no magnetic field needs to be applied for the device to function and achieve strong coupling. Strong coupling is achieved in use between the mechanical motion of the mechanical resonator 3 and the electromagnetic signal when a magnetic field applied to the mechanical resonator 3 is less than 5T, optionally less than 2T, optionally less than 1T, optionally less than 0.1T, optionally less than 0.01T, optionally where no magnetic field is applied.

To explore this, the present device 1 was compared to a commercial quartz crystal oscillator CC1V-T1A operating at a similar frequency. The present device, which is referred to as a transmission line electromechanics device (TLM) can operate as a low-loss inductor.

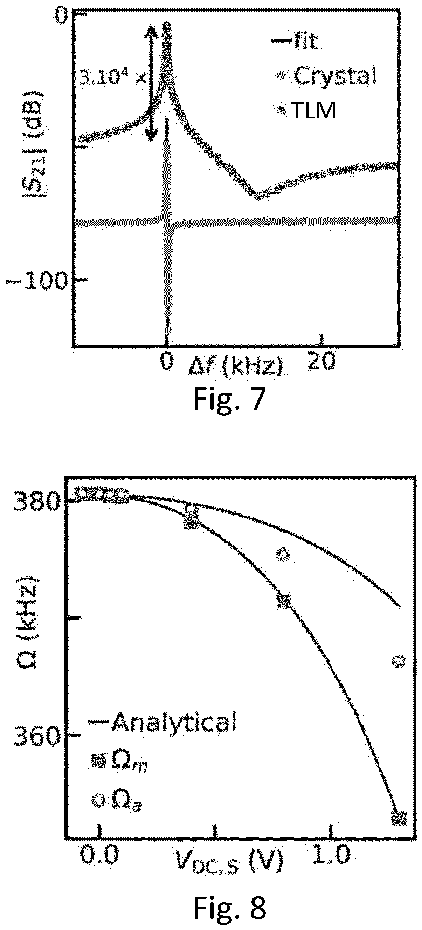

Fig. 7 compares $S_{21}$ around the resonance and anti-resonance for the crystal and the TLM at $V_{DC}$ = 1 V. The solid line represents a fit to the data. The TLM shows an insertion loss 30,000x (45 dB) lower than the crystal. The crystal presents an anti-resonance as expected from a Butterworth-van Dyke model, which predicts the transmission coefficient from the impedance of a gate capacitor in parallel to an RLC circuit. The TLM antiresonance is not as deep as predicted within a Butterworth-van Dyke model, but is well described by the addition of a shunt resistor to this model. The TLM also shows more than 12 kHz detuning between the resonance and the antiresonance, while the crystal has a detuning of less than 1 kHz.

Both the resonance and antiresonance frequencies are tuned by the DC bias voltage, but have different dependencies on the DC bias voltage. This means that at low DC bias voltages, there is very little detuning of the antiresonance. As DC bias voltage increases, the frequency of the resonance decreases faster than that of the antiresonance, increasing the detuning between the two. This is illustrated in Fig. 8, which shows the dependence of the anti-resonance frequency $\Omega_a$ and the resonance frequency $\Omega_m$ on DC bias voltage.

The solid line represents a fit of the voltage dependence from the mechanical resonance and the expected anti-resonance dependence based on this fit. Fitting the resonant frequency voltage dependence to Eq. 1 and allowing for a small voltage offset yields a zero-voltage frequency $\Omega_0$ within 0.07% of expectations based on fabrication parameters, and a zero-voltage separation distance $d$ = 320 nm, within 20 nm of the design values.

The measured resonance frequencies $\Omega_m$ are fitted to a parabola to obtain $\Omega_0$, the voltage shift and the separation distance. The similarity between target parameters and fitted values demonstrates excellent fabrication control. Eq. 2 predicts the voltage dependence of the antiresonant frequency to within 1.2% with no free parameters, although the experimental antiresonance systematically depends more strongly on voltage than expected.

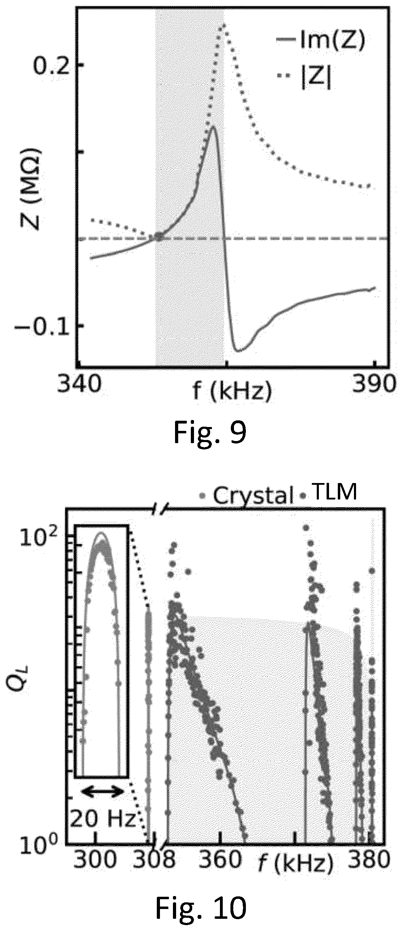

Given the prevalence of quartz crystal oscillators in electrical engineering, it is natural to view TLM as a circuit element characterized by a lumped-element impedance Z. Transforming the measured scattering parameters into an impedance reveals an inductive region defined by Im(Z) > 0 at frequencies between the resonance and antiresonance. This is illustrated in Fig. 9, which shows the imaginary and absolute impedance of the TLM data shown in Fig. 7. The grey shading indicates the region of inductive behaviour where Im(Z) > 0. The maximal equivalent inductance reaches remarkable values of Im($Z$)/$\omega$ = 0.320/$2\pi$Hz, and, unlike the quartz crystal oscillator, is unaffected by parasitic antiresonances over more than 11.8 kHz of bandwidth.

We quantify the quality of this effective inductance with the metric $Q_L = \dfrac{Im(Z)}{Re(Z)}$ , as shown in Fig. 10. Fig. 10 shows the inductor quality factor $Q_L$ measured data (marker points) and a fit to the data (solid line). The inset shows the commercial quartz crystal resonance and the shaded region indicates the voltage tuning range of $Q_L$.

We find $Q_L \approx 30$, which is comparable to that of the commercial quartz crystal. However, TLM maintains this $Q_L$ over more than 25 kHz of tuneable bandwidth by adjusting the DC voltage, compared to only 20Hz for the crystal oscillator, presenting a usable inductive region more than 1000x wider in frequency than the crystal.

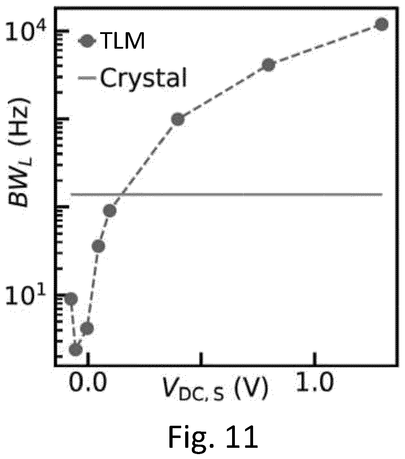

As shown in Fig. 11, the TLM device also shows an impressive inductor bandwidth ($BW_L$) at fixed DC voltage. In Fig. 11, points were calculated from the data shown in Fig. 10, and the line is a guide to the eye. $BW_L$ for the TLM surpasses 10 kHz at high voltages, while $BW_L$ for the crystal is fixed at around 100Hz. Thus, TLM shows promise as a compact, low insertion loss, high $Q_L$, and wide band inductor for electrical engineering.

A fundamental consequence of reaching strong electromechanical coupling (C > 1) is that the mechanical temperature is an average of the temperature of the incoming radiation. This means that mechanical motion of the mechanical resonator 3 thermalizes to radiation in the transmission lines and the internal dissipation. This can be represented be the two ports connected to external transmission lines and a virtual port responsible for the internal dissipation. However, at the relatively low operating frequencies used herein, thermomechanical fluctuations are obscured by technical noise associated with the measurement chain.

To overwhelm this technical noise, we introduce a pump tone functioning as a parametric drive. This demonstrates the viability of an amplifier comprising the electromechanical device described above. In such an amplifier, the controller is further configured to apply the parametric drive signal to the mechanical resonator 3.

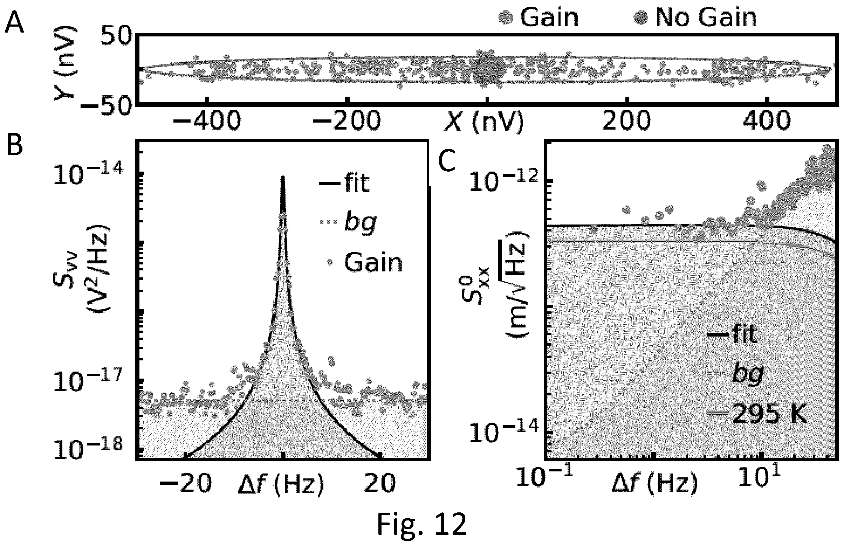

Fig. 12A shows the X and Y quadratures of the lock-in demodulator for TLM with and without parametric gain. The solid line represents 4x the standard deviation of the data. The introduction of the parametric drive causes a substantial gain in the $X$ quadrature and no significant change in the $Y$ quadrature.

Fig. 12B presents a voltage power spectral density obtained from the parametrically amplified trace shown in Fig. 12A. A Lorentzian fit (lor) is shown as a solid line and the input voltage noise density from the amplifier (bg) is shown as a dashed line. The green shading indicates the region dominated by the input voltage noise of the amplifier and the orange shading indicates the region dominated by thermomechanical fluctuations.

The voltage power spectral density consists of a Lorentzian parametric-gain profile on top of white noise background. The Lorentzian fit includes only the voltage fluctuations of the $X$ quadrature, since its amplified thermomechanical fluctuations dominate on resonance. In the high-gain limit the voltage fluctuation can be directly converted into equivalent undriven position imprecision $S_{xx}^0$ using the relation

$$S_{VV} = gm\Omega_m^2 |G(f)|^2 S_{xx}^0, \tag{3}$$

where $G(f)$ is the frequency-dependent gain of the quadrature being measured. The frequency dependent gain function is given by

$$G(f) = \begin{pmatrix} \frac{2\pi f - \frac{i\kappa}{2}}{2\pi f - i\kappa/(2G_A)} & 0 \\ 0 & \frac{2\pi f - \frac{i\kappa}{2}}{2\pi f - i\kappa/(2G_S)} \end{pmatrix}, \tag{5}$$

where $G_{A/S}$ is the gain of the amplified/unamplified quadrature.

Fig. 12C shows position imprecision for the parametrically amplified trace shown in Fig. 12A, and the Lorentzian fit (fit) and background (bg) shown in Fig. 12B. The full grey line represents the expected Lorentzian for a TLM at 295 K. At low frequency, the equivalent position imprecision follows the Lorentzian thermomechanical fluctuations, but at higher frequency is dominated by the background. The imprecision of single quadrature $S_{xx}^0$ reaches 12 fm \Hz on resonance, comparable to state-of-the-art cavity-free optical interferometers working towards ground state cooling [8]. The device can therefore be used to efficiently detect mechanical motion with a corresponding imprecision of 12 fm/√Hz, rivalling optical Michelson interferometers [8].

However, the thermomechanical fluctuations associated with the Lorentzian fit are equivalent to a temperature of 623 K, far exceeding the room temperature value. This value is consistent with independent measurements of the electrical back-action noise of the electronics in the measurement setup. The back-action noise in the measurement setup was inferred by terminating the input port of the amplifier with a resistor and measuring the voltage variance. Several resistors (R) in the range 2-50 Ω were measured and their voltage variance (Var(V)) was fit to Var(V)=bw($S_0$ + $S_{ii}R^2$ + $4k_B$TR), where bw is the amplifier bandwidth, $S_0$ is the input voltage noise, $S_{ii}$ is the current noise, and $k_B$ is the Boltzmann constant. The fit gives an input voltage noise of 4 nV/√Hz, matching the specification of the amplifier, and a current noise of 25 pA/√Hz, which is not described in the documentation of the amplifier.

Thus, unlike optical interferometers, the measurement apparatus associated with the present device 1 gives substantial back-action noise at the current imprecision. To overcome this drawback, a simple back-action isolation scheme was implemented to protect the mechanical resonator 3 from measurement noise.

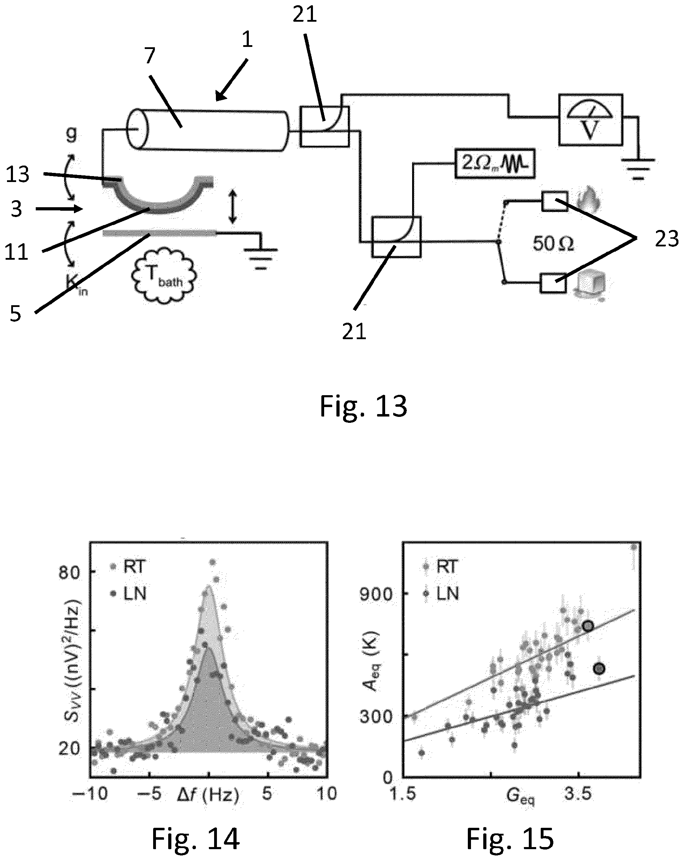

Fig. 13 illustrates the back-action isolation setup. The device 1 includes only the first transmission line 7 coupled to the first surface 13 and the virtual port, responsible for the internal loss. The electrode 5 is grounded. The input electromagnetic signal is added through the main line of a directional coupler 21 and the reflection read out through the coupled port. The transmission line 7 carries mainly the voltage fluctuations of a reference 50 Ω resistor 23 at liquid nitrogen (LN) or room temperature (RT). Therefore, the undriven mechanical temperature of the external port is defined by the incoming radiation from the mechanical bath and the reference resistor 23. The attenuation from the coupled port minimizes the back-action while allowing the reflected electromagnetic signal to be measured, albeit at the expense of increasing imprecision.

Fig. 14 presents the voltage spectral density for the TLM thermalized to the reference resistor 23 at LN and RT. The solid line represents a Lorentzian curve as a guide to the eye. The thermomechanical fluctuations are proportional to the area between the trace and the background, as indicated by the shading.

The Lorentzian shape of the thermomechanical fluctuations is still visible, although the height of the peak is largely decreased in comparison to Fig. 12B. This is as expected since the gain is attenuated by the coupled port. Most importantly, a clear height difference between the LN and RT traces can be observed, indicating that the mechanical resonator temperature is dominated by the voltage fluctuation of the reference resistor 23, rather than the lock-in amplifier. The equivalent mechanical temperature $T_m$ is proportional to the area $A$ of the Lorentzian part of the voltage spectral density

$$A_{eq} = G_{eq}T_m - \eta T, \qquad\qquad (4)$$

where $\eta$ is an insertion loss factor from the membrane to the voltage measurement that includes both the coupling and system losses, $G_{eq} = \eta G_A$ is the net mechanical gain, and $T$ is the temperature of the input mode.

Fig. 15 shows the numerically integrated area A under the curve of the thermomechanical fluctuations as a function of $G_{eq}$. The gain is independently measured with a pilot tone for each experimental run. The circled markers on the right-hand side of the plot correspond to the traces shown in Fig. 14. The solid line represents a fit of the gain dependence.

In Fig. 15, the expected mechanical temperature $T_m$ is 295 K for the room temperature load because all system components are in thermal equilibrium. Fitting to Eq. 4 gives $T_m = 280 \pm 7$ K for the room temperature load, as expected for a system thermalized to room temperature.

For the cold load, the expected mechanical temperature is given by $T_m = (g/\kappa)T_{in} + (\kappa_{in}/\kappa)T_{RT}$ where $T_{RT} = 295$ K and $T_{in}$ is the input radiation temperature. The parameters $g$, $\kappa_{in}$, and $\kappa$ are fixed from independently measured scattering parameters and $T_{in} = 105$ K from the temperature of liquid nitrogen and the measured insertion loss from the cold load to the sample. Fitting to Eq. 4 for the cold load yields $T_m = 170 \pm 7$ K, compatible with the expected value of $T_m = 177$ K based on independently measured system and resonator losses.

This demonstrates that the setup allows for the radiative cooling of a room temperature mechanical resonator by a remote cryogenic load. The technique also provides a method to characterize the temperature of unknown baths coupled to the device 1.

The spread of the points in Fig. 15 is not compatible with statistical errors. These occurred from gain instabilities, as the gain of the device fluctuates in an uncontrolled way at the high gains required to overwhelm the back action. Provided that these gain instabilities are cured, the TLM device provides a competitive candidate for a low noise amplifier in this frequency range, with added noise of only $250 \pm 20$ K. This is 20% less than comparable commercial amplifiers with the lowest noise figures in this frequency range.

**References**

[1] S. Groblacher, K. Hammerer, M. R. Vanner, and M. Aspelmeyer, Observation of strong coupling between a micromechanical resonator and an optical cavity field, Nature 460, 724 (2009).

[2] T. J. Kippenberg and K. J. Vahala, Cavity opto- mechanics, Optics express 15, 17172 (2007).

[3] J. Chan, T. M. Alegre, A. H. Safavi-Naeini, J. T. Hill, A. Krause, S. Groblacher, M. Aspelmeyer, and O. Painter, Laser cooling of a nanomechanical oscillator into its quantum ground state, Nature 478, 89 (2011).

[4] P. Rabl, P. Cappellaro, M. G. Dutt, L. Jiang, J. Maze, and M. D. Lukin, Strong magnetic coupling between an electronic spin qubit and a mechanical resonator, Physical Review B 79, 041302 (2009).

[5] S. Schmid, T. Bagci, E. Zeuthen, J. M. Taylor, P. K. Herring, M. C. Cassidy, C. M. Marcus, L. Guillermo Villanueva, B. Amato, A. Boisen, et al., Single-layer graphene on silicon nitride micromembrane resonators, Journal of Applied Physics 115 (2014).

[6] N. J. Engelsen, A. Arabmoheghi, M. J. Bereyhi, A. Beccari, S. A. Fedorov, Y. Xia, G. Huang, A. Zicoschi, and T. J. Kippenberg, Ultralow dissipation mechanical resonators for cavity-free quantum control, in 2023 Conference on Lasers and Electro-Optics (CLEO) (IEEE, 2023) pp. 1-2.

[7] A. Cleland and M. Roukes, External control of dissipation in a nanometer-scale radiofrequency mechanical resonator, Sensors and Actuators A: Physical 72, 256 (1999).

[8] C. M. Pluchar, A. R. Agrawal, E. Schenk, and D. J. Wilson, Towards cavity-free ground-state cooling of an acoustic-frequency silicon nitride membrane, Applied Optics 59, G107 (2020).

## Claims

1. An electromechanical device comprising:

   a mechanical resonator comprising a first surface;
   an electrode; and
   a controller, wherein:

      the first surface opposes the electrode and is separated from the electrode;
      the controller is configured to apply a bias signal comprising a DC bias voltage either a) between the first surface and the electrode, or b) between a first region of the electrode and a second region of the electrode; and
      the DC bias voltage and a configuration of the mechanical resonator and the electrode are such that strong coupling is achieved in use between mechanical motion of the mechanical resonator and an electromagnetic signal applied to one of the first surface and the electrode.

2. The device of claim 1, wherein the configuration of the mechanical resonator and the electrode comprises one or more of:

      a) a separation of the first surface from the electrode;
      b) a quality factor of the mechanical resonator; and
      c) dimensions of the mechanical resonator and/or the first surface.

3. The device of any preceding claim, wherein the device further comprises a first transmission line electrically connected to one of the first surface and the electrode for application of the electromagnetic signal, optionally wherein either a) the other of the first surface and the electrode is grounded, or b) the device further comprises a second transmission line electrically connected to the other of the first surface and the electrode.

4. The device of any preceding claim, wherein the DC bias voltage is between 0.1V and 30V, optionally between 0.5V and 5V.

5. The device of any preceding claim, wherein a separation of the first surface from the electrode when no DC bias voltage is applied by the controller is between $0.05\,\mu m$ and $5\,\mu m$, optionally between $0.1\,\mu m$ and $3\,\mu m$.

6. The device of any preceding claim, wherein one or both of:

      a) a quality factor of the mechanical resonator is greater than 500, optionally greater than 1000;
      b) a fundamental resonance frequency of the mechanical resonator when no DC bias voltage is applied by the controller is between 50kHz and 5MHz, optionally 300kHz and 600kHz.

7. The device of any preceding claim, wherein one or more of:

      a) an area of the first surface is between $1\,\mu m^2$ and $25\,mm^2$, optionally between $50{,}000\,\mu m^2$ and $300{,}000\,\mu m^2$;
      b) a smallest dimension of the first surface is at least 100nm, optionally at least $1\,\mu m$, optionally at least $50\,\mu m$; and
      c) mode matching of the electrode and the first surface is at least 20%, optionally at least 50%, optionally at least 80%.

8. The device of any preceding claim, wherein the mechanical resonator comprises a membrane and optionally one or more of:

   a) the membrane comprises silicon nitride;
   b) the membrane is soft-clamped at its edges; and
   c) a thickness of the membrane is at most 300nm, optionally at most 200nm, optionally at most 100nm.

9. The device of any preceding claim, wherein the first surface is electrically conductive, optionally wherein the first surface comprises a metal, for example aluminium, graphene, or a superconducting material.

10. The device of claim 9, wherein the first surface comprises a metal and a thickness of the metal is at most 150nm, optionally at most 100nm, optionally at most 50nm.

11. The device of any preceding claim, wherein the electrode comprises a) graphene, or b) a metal, for example platinum or aluminium, optionally wherein a thickness of the metal is at most 200nm, optionally at most 100nm, optionally at most 50nm.

12. An amplifier comprising the electromechanical device of any preceding claim, wherein the controller is further configured to apply a parametric drive signal to the mechanical resonator.

13. A bandpass filter or an inductor comprising the electromechanical device of any of claims 1 to 11.

14. A method of coupling an electromagnetic signal to mechanical motion using an electromechanical device, wherein the electromechanical device comprises:

   an electrode; and
   a mechanical resonator comprising a first surface opposing the electrode and separated from the electrode,
   the method comprising:

   applying a DC bias voltage either a) between the first surface and the electrode, or b) between a first region of the electrode and a second region of the electrode; and applying the electromagnetic signal to the first surface or the electrode,
   wherein the DC bias voltage and a configuration of the mechanical resonator and the electrode are such that strong coupling is achieved between mechanical motion of the mechanical resonator and the electromagnetic signal.

15. The method of claim 14, wherein a frequency of the electromagnetic signal is between 100kHz and 10MHz, optionally 300kHz and 600kHz.

Fig. 1

Fig. 2

Fig. 3

Fig. 4

Fig. 5

Fig. 6

Fig. 7

Fig. 8

Fig. 9

Fig. 10

Fig. 11

Fig. 12

Fig. 13

Fig. 14

Fig. 15

Europäisches
Patentamt

European
Patent Office

Office européen
des brevets

**EUROPEAN SEARCH REPORT**

Application Number

EP 24 18 3669

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 2012/105173 A1 (SCHOEN FLORIAN [DE] ET AL) 3 May 2012 (2012-05-03) <br> * paragraph [0042] - paragraph [0044]; claim 10; figure 2 * <br> * paragraph [0029] * | 1-15 | INV. <br> H03H9/02 <br> H03H9/24 |
| X | US 2020/407218 A1 (CHODAVARAPU VAMSY [CA] ET AL) 31 December 2020 (2020-12-31) <br> * paragraph [0063]; figure 1 * <br> * paragraph [0022] * | 1-8, 11-15 | |
| X | NGUYEN C T-C: "MICROMECHANICAL CIRCUITS FOR COMMUNICATIONS", INTERNATIONAL CONFERENCE ON HIGH-DENSITY INTERCONNECT AND SYSTEMS PACKAGING, XX, XX, 24 April 2000 (2000-04-24), pages 112-117, XP008000467, <br> * page 113, column 2, paragraph 2; figure 1 * <br> * page 114, column 2, paragraph 3 * | 1-15 | |
| X | US 11 811 380 B2 (OHIO STATE INNOVATION FOUNDATION [US]) 7 November 2023 (2023-11-07) <br> * figure 9 * | 1-7, 11-15 | TECHNICAL FIELDS SEARCHED (IPC) <br><br> H03H |
| X | US 2007/052497 A1 (TADA MASAHIRO [JP]) 8 March 2007 (2007-03-08) <br> * paragraph [0005]; figure 1 * | 1-7,9-15 | |

-/--

The present search report has been drawn up for all claims

| Place of search | Date of completion of the search | Examiner |
|---|---|---|
| Munich | 15 November 2024 | Schnabel, Florian |

EPO FORM 1503 03.82 (P04C01)

page 1 of 2

**EUROPEAN SEARCH REPORT**

Application Number

EP 24 18 3669

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | MAHMOUD KALAEE ET AL: "Quantum electromechanics of a hypersonic crystal", ARXIV.ORG, CORNELL UNIVERSITY LIBRARY, 201 OLIN LIBRARY CORNELL UNIVERSITY ITHACA, NY 14853, 14 August 2018 (2018-08-14), XP081179905, DOI: 10.1038/S41565-019-0377-2 * page 8, column 1, paragraph 1; figure 1 * * page 2, column 1, paragraph 2 * * page 4, column 1, paragraph 1 * ----- | 1-8, 11-15 | |
| X | US 2022/238172 A1 (ALEMÁN BENJAMÍN J [US] ET AL) 28 July 2022 (2022-07-28) * paragraph [0006] - paragraph [0043]; figure 1 * ----- | 1-9, 11-15 | |

TECHNICAL FIELDS SEARCHED (IPC)

The present search report has been drawn up for all claims

| Place of search | Date of completion of the search | Examiner |
|---|---|---|
| Munich | 15 November 2024 | Schnabel, Florian |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons
& : member of the same patent family, corresponding document

EPO FORM 1503 03.82 (P04C01)

page 2 of 2

# EP 4 668 580 A1

## ANNEX TO THE EUROPEAN SEARCH REPORT
## ON EUROPEAN PATENT APPLICATION NO.

EP 24 18 3669

This annex lists the patent family members relating to the patent documents cited in the above-mentioned European search report.
The members are as contained in the European Patent Office EDP file on
The European Patent Office is in no way liable for these particulars which are merely given for the purpose of information.

15-11-2024

| Patent document cited in search report | | Publication date | Patent family member(s) | | Publication date |
|---|---|---|---|---|---|
| US 2012105173 | A1 | 03-05-2012 | DE | 102010029284 A1 | 13-01-2011 |
| | | | US | 2010301967 A1 | 02-12-2010 |
| | | | US | 2012105173 A1 | 03-05-2012 |
| US 2020407218 | A1 | 31-12-2020 | US | 2020407218 A1 | 31-12-2020 |
| | | | US | 2023308076 A1 | 28-09-2023 |
| US 11811380 | B2 | 07-11-2023 | JP | 2022526254 A | 24-05-2022 |
| | | | KR | 20210142669 A | 25-11-2021 |
| | | | US | 2022158602 A1 | 19-05-2022 |
| | | | WO | 2020186180 A1 | 17-09-2020 |
| US 2007052497 | A1 | 08-03-2007 | CN | 1836371 A | 20-09-2006 |
| | | | EP | 1650868 A1 | 26-04-2006 |
| | | | JP | 4501860 B2 | 14-07-2010 |
| | | | JP | WO2005004326 A1 | 17-08-2006 |
| | | | KR | 20060026905 A | 24-03-2006 |
| | | | TW | I255580 B | 21-05-2006 |
| | | | US | 2007052497 A1 | 08-03-2007 |
| | | | WO | 2005004326 A1 | 13-01-2005 |
| US 2022238172 | A1 | 28-07-2022 | US | 2022238172 A1 | 28-07-2022 |
| | | | WO | 2020243201 A1 | 03-12-2020 |

EPO FORM P0459

For more details about this annex : see Official Journal of the European Patent Office, No. 12/82

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Non-patent literature cited in the description**

- **S. GROBLACHER** ; **K. HAMMERER** ; **M. R. VANNER** ; **M. ASPELMEYER**. Observation of strong coupling between a micromechanical resonator and an optical cavity field. *Nature*, 2009, vol. 460, 724
- **T. J. KIPPENBERG** ; **K. J. VAHALA**. Cavity optomechanics. *Optics express*, 2007, vol. 15, 17172
- **J. CHAN** ; **T. M. ALEGRE** ; **A. H. SAFAVI-NAEINI** ; **J. T. HILL** ; **A. KRAUSE** ; **S. GROBLACHER** ; **M. ASPELMEYER** ; **O. PAINTER**. Laser cooling of a nanomechanical oscillator into its quantum ground state. *Nature*, 2011, vol. 478, 89
- **P. RABL** ; **P. CAPPELLARO** ; **M. G. DUTT** ; **L. JIANG** ; **J. MAZE** ; **M. D. LUKIN**. Strong magnetic coupling between an electronic spin qubit and a mechanical resonator. *Physical Review B*, 2009, vol. 79, 041302

- **S. SCHMID** ; **T. BAGCI** ; **E. ZEUTHEN** ; **J. M. TAYLOR** ; **P. K. HERRING** ; **M. C. CASSIDY** ; **C. M. MARCUS** ; **L. GUILLERMO VILLANUEVA** ; **B. AMATO** ; **A. BOISEN et al.** Single-layer graphene on silicon nitride micromembrane resonators. *Journal of Applied Physics*, 2014, vol. 115
- Ultralow dissipation mechanical resonators for cavity-free quantum control. **N. J. ENGELSEN** ; **A. ARABMOHEGHI** ; **M. J. BEREYHI** ; **A. BECCARI** ; **S. A. FEDOROV** ; **Y. XIA** ; **G. HUANG** ; **A. ZICOSCHI** ; **T. J. KIPPENBERG**. 2023 Conference on Lasers and Electro-Optics (CLEO). IEEE, 2023, 1-2
- **A. CLELAND** ; **M. ROUKES**. External control of dissipation in a nanometer-scale radiofrequency mechanical resonator. *Sensors and Actuators A: Physical*, 1999, vol. 72, 256
- **C. M. PLUCHAR** ; **A. R. AGRAWAL** ; **E. SCHENK** ; **D. J. WILSON**. Towards cavity-free ground-state cooling of an acoustic-frequency silicon nitride membrane. *Applied Optics*, 2020, vol. 59, G107